# EUROPÄISCHE PATENTSCHRIFT

(11) **EP 2 884 297 B1**
(45) Veröffentlichungstag und Bekanntmachung des Hinweises auf die Patenterteilung: **11.09.2019**
(21) Anmeldenummer: 14190196.7
(22) Anmeldetag: 24.10.2014
(51) Int. Cl.: G01R 33/00, G01R 15/18, G01R 15/20, G01R 15/14

(54) **Stromsensor und Regelschaltung**
Current sensor and control circuit
Détecteur de courant et circuit de réglage

(30) Priorität: 11.12.2013 DE 102013225645
(43) Veröffentlichungstag der Anmeldung: 17.06.2015
(73) Patentinhaber: Deere & Company, Moline, IL 61265 (US); John Deere GmbH & Co KG, 68163 Mannheim (DE)
(72) Erfinder: Krah, Jens Onno, 42327 Wuppertal (DE); Stahlhut, Ronnie D, Bettendorf, IA, 52722 (US)
(74) Vertreter: Holst, Sönke

(56) Entgegenhaltungen:
- EP-A1- 2 400 309
- DE-A1- 10 062 292
- DE-A1-102008 030 411
- SI-A- 9 800 063
- US-A1- 2012 001 617
- US-B1- 6 366 076
- SIMON P L C ET AL: "AUTOCALIBRATION OF SILICON HALL DEVICES", SENSORS AND ACTUATORS A, ELSEVIER SEQUOIA S.A., LAUSANNE, CH, Bd. A52, Nr. 1/03, 1. März 1996 (1996-03-01), Seiten 203-206, XP000599994, ISSN: 0924-4247, DOI: 10.1016/0924-4247(96)80150-6

## Beschreibung

Die Erfindung betrifft einen Stromsensor zur Erfassung der Stromstärke eines einen Leiter durchfließenden Stromes sowie eine Regelschaltung mit einem derartigen Stromsensor.

### Technologischer Hintergrund

Zur Erfassung der Stromstärke eines einen Leiter durchfließenden Stromes sind neben Shunt-Widerständen, die den Nachteilen von Energieverlusten und fehlender Potentialtrennung unterliegen, Stromsensoren bekannt, welche das durch den im Leiter fließenden Strom generierte Magnetfeld erfassen. Hierfür werden im Stand der Technik insbesondere Hallsensoren sowie Induktionswicklungen verwendet.

Hall-Sensoren beruhen auf dem Hall-Effekt, der einen in einem Festkörper (in der Regel einem Halbleiterkristall) fließenden Strom durch die Lorenz-Kraft quer zur Strom- und Magnetfeldrichtung ablenkt. Sie sind auch in der Lage, Gleichströme zu erfassen. Eine Schwäche der Hall-Sensoren liegt jedoch in einem relativ hohen Rauschanteil des Signals, insbesondere bei höheren Frequenzen. Außerdem sind die Hall-Spannungen temperaturabhängig, denn der Offset (Ausgangsspannung bei fehlenden Magnetfeld) und die Empfindlichkeit oder Verstärkung (Ausgangsspannung je Magnetfluss) verändern sich in Abhängigkeit von der jeweiligen Temperatur des Hall-Sensors.

Induktionswicklungen erfassen hingegen die zeitliche Änderung des magnetischen Flusses. Sie sind naturgemäß nicht zur Erfassung von Gleichströmen geeignet.

Im Stand der Technik wurde vorgeschlagen, Stromsensoren mit Kombinationen von Hall-Sensoren und Induktionswicklungen auszustatten:
Gemäß der SI 98 00 063 A sind einem Leiter benachbart ein Hall-Sensor und eine Induktionsspule angeordnet. Die Signale des Hall-Sensors werden durch einen Tiefpass geleitet, während die Signale der Induktionsspule zeitlich hochintegriert und durch einen Hochpass geleitet werden. Die Zeitkonstanten des Hoch- und Tiefpasses stimmen überein. Die Ausgangssignale des Tief- und Hochpasses werden addiert. Die tieffrequenten Anteile des Stromes durch den Leiter werden somit durch den Hall-Sensor erfasst und die hochfrequenten Anteile durch die Induktionsspule. Hier stellt sich dennoch das Problem der Temperaturabhängigkeit der Empfindlichkeit und des Offsets des Hall-Sensors.

Die DE 10 2008 030 411 A1 verwendet ebenfalls einen Hall-Sensor und eine Induktionsspule, um das Magnetfeld eines als Spule ausgeführten Leiters zu erfassen. Die Signale des Hall-Sensors werden einem Tiefpass zugeführt und auch die Signale der Induktionsspule durch einen Tiefpass geleitet. Die Ausgangssignale beider Tiefpässe werden, jeweils nach Multiplikation mit einem zugehörigen Gewichtungsfaktor, addiert. Eine weitere, dem Hall-Sensor benachbarte Wicklung ist mit einer Steuereinheit verbunden. Bei nicht vorhandenem Messstrom im Leiter wird die weitere Wicklung (oder die Induktionsspule) mit einem Strom beaufschlagt, um anhand der dann auftretenden Ausgangsspannung des Hall-Sensors dessen Offset- und Verstärkungsfehler zu berechnen und diese dann bei der Signalverarbeitung zu berücksichtigen. Außerdem kann ein Temperatursensor eine eventuelle Temperaturänderung messen, um eine daraus resultierende Drift des Offsets und/oder der Empfindlichkeit des Hall-Sensors zu kompensieren. Der Temperatursensor vergrößert den Aufwand und erfordert eine genaue Kalibrierung zur Kompensation der Temperaturabhängigkeit der Signale des Hall-Sensors, während die Beaufschlagung des Hall-Sensors mit dem Magnetfeld der weiteren Wicklung oder der Induktionsspule nur bei nicht vorhandenem Messstrom und somit nicht kontinuierlich möglich ist.

Die EP 2 400 309 A1 beschreibt einen Stromsensor mit einem magnetischen Kern, durch dessen mittige Öffnung ein Leiter mit einem zu messenden Strom verläuft. In einem Spalt des Kerns ist ein Hallsensor angeordnet, dessen Ausgangssignal durch einen Verstärker verstärkt wird. Eine Kalibrierwicklung ist um den magnetischen Kern gewickelt und erzeugt ein magnetisches Wechselfeld, dessen Frequenz ca. 10 mal höher als die maximal zu messende Frequenz des Stromes ist. Am Ausgang des Verstärkers wird diese Frequenz abgenommen, gleichgerichtet und zur Bestimmung der Verstärkung des Verstärkers verwendet. Das durch einen Tiefpass zur Ausfilterung des Kalibriersignals geleitete Ausgangssignal des Verstärkers dient dann als Ausgangssignal des Stromsensors. Hier erfolgt somit eine kontinuierliche Kalibrierung des Hallsensors während der Messung, jedoch bei recht hohen Frequenzen, bei denen der Hallsensor einen hohen Rauschanteil im Signal liefert.

### Aufgabe

Die vorliegende Erfindung hat sich zur Aufgabe gesetzt, einen verbesserten Stromsensor bereitzustellen.

### Erfindung

Die vorliegende Erfindung wird durch die Patentansprüche definiert.

Ein Stromsensor zur Erfassung der Stromstärke eines einen Leiter durchfließenden Stromes umfasst eine dem Leiter zugeordnete Induktionswicklung, welche ein zur zeitlichen Ableitung der Stromstärke proportionales Induktionssignal bereitstellt, einen dem Leiter zugeordneten Hall-Sensor, der ein zur Stromstärke proportionales Hall-Signal bereitstellt, und eine dem Hall-Sensor zugeordnete Kalibrierwicklung, die durch einen Generator kontinuierlich mit einem Kalibrierstrom definierter Frequenz beaufschlagbar ist, der ein definiertes Magnetfeld im Hall-Sensor bewirkt. Der Eingang einer ersten Auswertungsschaltung ist mit der Induktionswicklung verbunden und erhält demnach das Induktionssignal. Der Eingang einer zweiten Auswertungsschaltung, die einen Tiefpass umfasst, ist mit dem Hall-Sensor verbunden und erhält das Hall-Signal. Eine dritte Auswertungsschaltung ist mit dem Ausgang der zweiten Auswertungsschaltung verbunden und evaluiert im Betrieb einen dem Kalibrierstrom zuordenbaren Teil des Hall-Signals und verwendet letzteren zur Festlegung eines Parameters der zweiten Auswertungsschaltung. Eine vierte Auswertungsschaltung dient zur Erzeugung eines die Stromstärke repräsentierenden Ausgangssignals, das die Summe des Ausgangssignals der ersten Auswertungsschaltung und des Ausgangssignals der zweiten Auswertungsschaltung abzüglich des dem Kalibrierstrom zuordenbaren Teils des Ausgangssignals der zweiten Auswertungsschaltung (der als Signal hinsichtlich der Amplitude und der Phase der dem Kalibrierstrom definierter Frequenz zuordenbaren Signalanteile der Ausgangsspannung der zweiten Auswertungsschaltung von der dritten Auswertungsschaltung bereitgestellt wird) darstellt. Dazu kann die vierte Auswertungsschaltung den dem Kalibrierstrom zuordenbaren Teil des Ausgangssignals der zweiten Auswertungsschaltung vom Ausgangssignal der zweiten Auswertungsschaltung subtrahieren und einen Addierer zur Summierung der Ausgangssignale der ersten Auswertungsschaltung und dem Ergebnis der Subtraktion umfassen. Das Ausgangssignal des Addierers repräsentiert die Stromstärke des durch den Leiter fließenden Stromes.

Mit anderen Worten wird das Magnetfeld, das der Strom durch den Leiter erzeugt, durch zwei Sensoren erfasst, nämlich durch die Induktionswicklung und durch den Hall-Sensor. Der Rauschanteil des Signals des Hall-Sensors wird durch einen Tiefpass der zweiten Auswertungsschaltung abgetrennt, sodass der Ausgang der zweiten Auswertungsschaltung nur den Gleichstromanteil und den niederfrequenten Anteil des Stroms repräsentiert. Um die erwähnten temperaturabhängigen Parameter des Hall-Sensors zu kompensieren, wird eine zusätzliche Kalibrierwicklung durch einen Generator mit einem Kalibrierstrom mit einer definierten Frequenz beaufschlagt. Durch die Kalibrierwicklung wird ein Magnetfeld erzeugt, das durch den Hall-Sensor nachgewiesen wird. Bei einem bekannten Kalibrierstrom ist auch ein bestimmtes, bekanntes Hall-Signal zu erwarten. Das gemessene Hall-Signal kann jedoch u.a. aufgrund thermischer Einflüsse oder Alterung des Hall-Sensors davon abweichen. Eine dritte Auswertungsschaltung extrahiert aus dem Signal des Hall-Sensors den Anteil, der auf den Kalibrierstrom zurückführbar ist. Dabei kann insbesondere die Amplitude und Phasenlage des erwähnten Anteils des Signals des Hall-Sensors erfasst werden, aus denen sich die Empfindlichkeit und/oder der Offset des Hall-Sensors ableiten lassen. Anhand der evaluierten Größen des Anteils wird - vorzugsweise im Vergleich mit zu erwartenden Größen - ein Parameter der zweiten Auswertungsschaltung festgelegt. So kann beispielsweise die Verstärkung der zweiten Auswertungsschaltung von der evaluierten Empfindlichkeit des Hall-Sensors abhängen, um eine unerwartet hohe oder niedrige Empfindlichkeit zu kompensieren. Ggf. kann analog der evaluierte Offset des Hall-Sensors (d.h. die an ihm anliegende Spannung, wenn kein Magnetfeld vorhanden ist) kompensiert werden, indem ein entsprechender Wert vom Eingangs- oder Ausgangssignal der zweiten Auswertungsschaltung abgezogen wird.

Damit der Kalibrierstrom nicht die gleichzeitig laufende Messung der Stromstärke durch den Leiter stört, ist die vierte Auswertungsschaltung vorgesehen, welche den dem Kalibrierstrom zuordenbaren Teil des Ausgangssignals der zweiten Auswertungsschaltung vom Ausgangssignal der zweiten Auswertungsschaltung abzieht. Am Ausgang des für diesen Zweck vorgesehenen Subtrahierers der vierten Auswertungsschaltung ist das Kalibriersignal somit entfernt worden, sodass dort ein unverfälschtes, tiefpassgefiltertes Hall-Signal bereitsteht. Dieses Signal wird durch einen Addierer mit dem Ausgangssignal einer ersten Auswertungsschaltung summiert, die eingangsseitig mit dem Signal der Induktionswicklung beaufschlagt wird. Das Ausgangssignal des Addierers ist auch das Ausgangssignal des Stromsensors. Es besteht auch die Möglichkeit, zunächst die Signale der ersten und zweiten Auswertungsschaltung zu addieren und schließlich den dem Kalibrierstrom zuordenbaren Teil des Ausgangssignals der zweiten Auswertungsschaltung zu subtrahieren.

Auf diese Weise erhält man einen bis in den Gleichstrombereich hinunter sensitiven Stromsensor, der trotz relativ geringen Rauschens eine große Bandbreite aufweist und bei dem Alterungs- und Temperatureinflüsse des Hall-Sensors selbsttätig und kontinuierlich, d.h. auch während der Messung, kompensiert werden.

Bei einer bevorzugten Ausführungsform umfasst die erste Auswertungsschaltung einen Integrator und einen Hochpass. Durch die Integration erreicht man, dass das Ausgangssignal der ersten Auswertungsschaltung nicht mehr zur Zeitableitung des Magnetfelds, sondern direkt dem Magnetfeld und somit der Stromstärke durch den Leiter proportional ist. Die Signale der Induktionswicklung und des Hallsensors können dann durch den Addierer problemlos addiert werden. Es wäre jedoch auch denkbar, entsprechend der Vorgehensweise nach DE 10 2008 030 411 A1 die erste Auswertungsschaltung lediglich mit einem Tiefpass auszustatten.

Der von der dritten Auswertungsschaltung festgelegte Parameter der zweiten Auswertungsschaltung kann, wie bereits erwähnt, die dessen Empfindlichkeit des Hall-Sensors sein. Es besteht auch die Möglichkeit, durch die dritte Auswertungsschaltung die Übertragungsfunktion des Hall-Sensors zu evaluieren und in der zweiten Auswertungsschaltung zu berücksichtigen.

Der Kalibrierstrom ist rein sinusförmig. Seine Frequenz liegt unterhalb der Übergangsfrequenz des Tiefpasses der zweiten Auswertungsschaltung, damit der auf den Kalibrierstrom zurückführbare Anteil des Ausgangssignals der zweiten Auswertungsschaltung (d.h. am Ausgang der zweiten Auswertungsschaltung) durch die dritte Auswertungsschaltung erfasst werden kann.

Die Übertragungsfunktionen des Hochpasses der ersten Auswertungsschaltung und des

Tiefpasses der zweiten Auswertungsschaltung werden zweckmäßigerweise derart dimensioniert, dass ihre Summe 1 beträgt. Dadurch wird ein flacher Frequenzgang des Stromsensors erreicht.

Die dritte Auswertungsschaltung kann zwecks der Evaluierung des dem Kalibrierstrom zuordenbaren Teils des Ausgangssignals der zweiten Auswertungsschaltung eine diskrete Fouriertransformation durchführen.

Die Induktionswicklung und die Kalibrierwicklung können einen den Leiter konzentrisch umschließenden Ringkern umschließen, der eine Lücke hat, in welcher der Hall-Sensor angeordnet ist. Die erwähnten Wicklungen können eine ganze Windung oder mehrere Windungen aufweisen. Der Hall-Sensor, der Ringkern und die beiden Induktionswicklungen können auf einer einzigen Leiterkarte montiert werden. Alternativ können der Leiter, der Hall-Sensor und die Induktionswicklungen auf einem Chip (monolithisch) integriert werden, insbesondere wenn man auf den Ringkern verzichtet.

Der beschriebene Stromsensor eignet sich insbesondere zur Verwendung in einer Regelschaltung zur Kontrolle eines Verbrauchers, bei dem der Strom in einer zum Verbraucher führenden Leitung mit einem erfindungsgemäßen Stromsensor erfasst und das Ausgangssignal des Stromsensors der Regelschaltung zugeführt wird. Wenn der Verbraucher durch drei phasenversetzte Leitungen versorgt wird (z.B. bei einem Drehstrommotor), denen jeweils ein Stromsensor zugeordnet ist, können die Kalibrierwicklungen aller drei Stromsensoren in Serie geschaltet werden. Es wird somit nur ein einziger Generator für alle drei Stromsensoren benötigt.

### Ausführungsbeispiel

In den Zeichnungen ist ein nachfolgend näher beschriebenes Ausführungsbeispiel der Erfindung dargestellt, wobei die Bezugszeichen nicht zu einer einschränkenden Auslegung der Patentansprüche herangezogen werden dürfen. Es zeigt:
Fig. 1 eine Schemazeichnung eines Stromsensors, und
Fig. 2 ein Schema einer Regelschaltung zur Kontrolle eines Verbrauchers mit drei Stromsensoren.

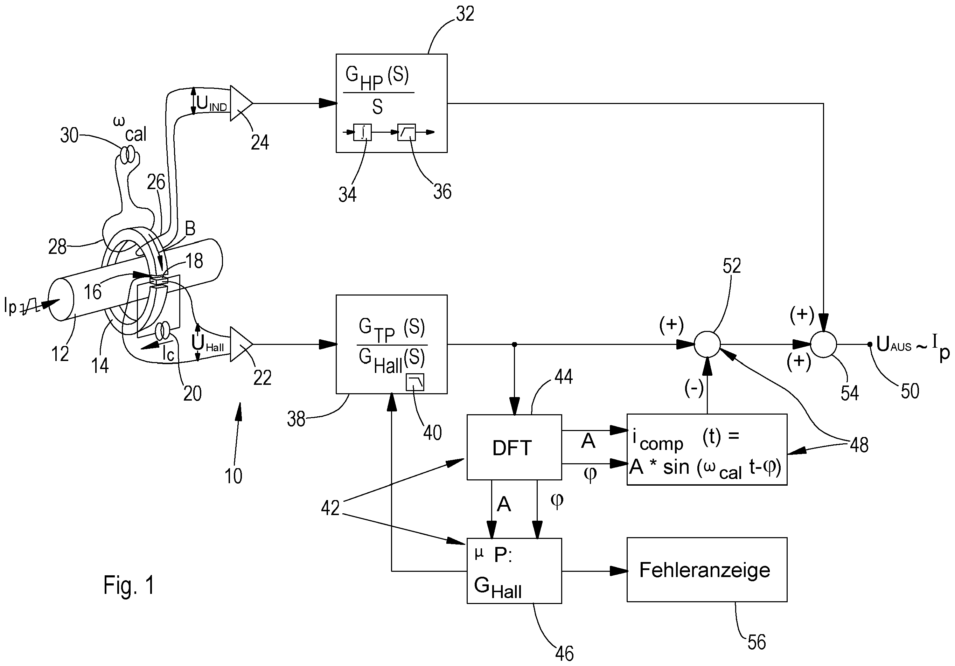

Die Figur 1 zeigt ein schematisches Diagramm eines insgesamt mit dem Bezugszeichen 10 gekennzeichneten Stromsensors, der zur Erfassung der Stromstärke I_{P} eines elektrischen Stromes durch einen Leiter 12 dient. Um den Leiter ist konzentrisch ein Ringkern 14 angeordnet, der eine Lücke 16 umfasst, in welcher ein Hall-Sensor 18 positioniert ist. Der Hall-Sensor 18 ist vorzugsweise ein Halbleiterkristall, der durch eine Stromquelle 20 mit einem konstanten, festen Strom I_{C} beaufschlagt wird, der in einer zum Leiter 12 parallelen Richtung durch den Hall-Sensor 18 fließt. Die Hall-Spannung U_{H} wird an den radial inneren und äußeren Flächen des Hall-Sensors 18 abgenommen und einem ersten Verstärker 22 zugeführt.

Um den Ringkern 14 ist weiterhin eine Induktionsspule 26 geschlungen, die in der dargestellten Ausführungsform eine einzige Windung hat, obwohl sie auch nur einen Bruchteil einer Windung oder ein Vielfaches davon aufweisen könnte. Das Ausgangssignal der Induktionsspule 26 wird einem zweiten Verstärker 24 zugeführt.

Außerdem ist eine Kalibrierwicklung 28 um den Ringkern 14 gelegt, die in der dargestellten Ausführungsform eine einzige Windung hat, obwohl sie auch nur einen Bruchteil einer Windung oder ein Vielfaches davon aufweisen könnte. Die Kalibrierwicklung 28 wird durch eine Wechselstromquelle 30 kontinuierlich mit einem rein sinusförmigen Wechselstrom ω_{cal} definierter Frequenz und Amplitude beaufschlagt.

Das Ausgangssignal des zweiten Verstärkers 24 wird einer ersten Auswertungsschaltung 32 zugeführt, die einen Integrator 34 und einen Hochpass 36 umfasst. Die Übertragungsfunktion der ersten Auswertungsschaltung 32 lässt sich im Laplace-Bereich (d.h. im Frequenzbereich) durch G_{HP}(s)/s beschreiben, wobei 1/s die Integration durch den Integrator ist und G_{HP}(s) die Übertragungsfunktion des Hochpasses 36.

Das Ausgangssignal des ersten Verstärkers 22 wird einer zweiten Auswertungsschaltung 38 zugeführt, die einen Tiefpass 40 umfasst. Die Übertragungsfunktion der zweiten Auswertungsschaltung lässt sich im Laplace-Bereich durch G_{TP}(s)/ G_{Hall}(S) beschreiben. Dabei ist G_{TP}(s) die Übertragungsfunktion des Tiefpasses. Durch die Multiplikation mit 1/G_{Hall}(s), d.h. dem Reziproken der (bekannten) Übertragungsfunktion des Hall-Sensors 18 werden dessen Übertragungseigenschaften (Frequenzgang, Empfindlichkeit, Offset) kompensiert. Die Summen der Übertragungsfunktionen G_{TP}(s) des Tiefpasses und G_{HP}(s) des Hochpasses ist vorzugsweise gleich 1.

Das Ausgangssignal der zweiten Auswertungsschaltung 38 wird einer dritten Auswertungsschaltung 42 zugeführt, die sich aus einer diskreten Fouriertransformationsschaltung 44 und einem Evaluator 46 zusammensetzt. Die diskrete Fouriertransformationsschaltung 44 extrahiert (mittels einer entsprechenden Fouriertransformation) die dem Wechselstrom ω_{cal} durch die Kalibrierspule 28 zuordenbaren Signalanteile der Ausgangsspannung der zweiten Auswertungsschaltung 38. Diese Signalanteile werden in Form eines Signals hinsichtlich der Amplitude A und der Phase ϕ des auf das Kalibriersignal zurückzuführenden Signalanteils an eine vierte Auswertungsschaltung 48 und an den Evaluator 46 übermittelt. Der Evaluator 46 bestimmt anhand dieser Signale (Amplitude A und der Phase ϕ des auf das Kalibriersignal zurückzuführenden Signalanteils des Ausgangssignals der zweiten Auswertungsschaltung 38) die Übertragungsfunktion G_{Hall} des Hall-Sensors 18, insbesondere dessen Empfindlichkeit und Offset, vorzugsweise auch dessen Frequenzgang. Diese Übertragungsfunktion oder Parameter davon werden durch den Evaluator 46 an die zweite Auswertungsschaltung 38 übergeben, die kontinuierlich ihre eigene Übertragungsfunktion an die vom Evaluator 46 erhaltenen Parameter anpasst. Auf diese Weise werden durch den Evaluator 46 die Signale des Hall-Sensors 18 mit zu erwartenden Signalen verglichen und eventuelle Temperaturabhängigkeiten und/oder Alterungserscheinungen des Hall-Sensors 18 kompensiert.

Der Evaluator 46 ist außerdem mit einer Fehleranzeige 56 verbunden, die dann aktiviert wird, wenn die dem Wechselstrom ω_{cal} durch die Kalibrierspule 28 zuordenbaren Signalanteile der Ausgangsspannung der zweiten Auswertungsschaltung 38 (oder eine daraus abgeleitete Größe) um mehr als ein Schwellenwert von zu erwartenden Werten abweichen. Auf diese Weise kann beispielsweise festgestellt werden, wenn der Hall-Sensor 18 oder der erste Verstärker 22 oder die zweite Auswertungsschaltung 38 einen Defekt haben sollten. Der Stromsensor 10 würde dann eine falsche Ausgangsspannung liefern, die ungünstigsten Falls dazu führt, dass eine Regelung einen Verbraucher mit einem zu hohen Strom beaufschlagt und beschädigt oder zerstört. Die Fehleranzeige 56 kann hingegen an die Regelung gegeben werden, die den Verbraucher dann herabregelt.

Um zu verhindern, dass der Wechselstrom ω_{cal} bis in den Ausgang 50 des Stromsensors 10 gelangt, ist die vierte Auswertungsschaltung 48 vorgesehen. Sie erzeugt einen Ausgangswert I_{comp}(t) = A sin(ω_{cal}t-ϕ), der einem Subtrahierer 52 zugeführt wird, der diesen Ausgangswert von der Ausgangsspannung der zweiten Auswertungsschaltung 38 subtrahiert. Am Ausgang des Subtrahierers 52 steht demnach eine Spannung zur Verfügung, die dem Ausgangssignal des Hall-Sensors 18 entspricht, von dem aber die auf die Kalibrierspule 28 zurückzuführenden Signalanteile entfernt wurden.

Die Ausgangsspannung des Subtrahierers 52 und der ersten Auswertungsschaltung 32 werden durch einen (ebenfalls zur vierten Auswertungsschaltung 32 gehörenden) Addierer 54 addiert, an dessen Ausgang 50 schließlich die zum zu erfassenden Strom I_{P} durch den Leiter 12 proportionale Ausgangsspannung zur Verfügung steht.

Die Frequenz des Wechselstroms ω_{cal} ist niedriger als die Übergangsfrequenz des Tiefpasses 36, damit der Wechselstroms ω_{cal} im Ausgangssignal der ersten Auswertungsschaltung 32 nicht nachweisbar ist.

Die dargestellten Komponenten des Stromsensors 10 können analog oder digital arbeiten. Anstelle, wie hier dargestellt, im Zeitbereich, könnten sie auch (nach einer Fouriertransformation) im Frequenzbereich arbeiten und schließlich wieder eine Transformation in den Zeitbereich erfolgen.

Die Funktionsweise des Stromsensors 10 ist nach alledem folgendermaßen. Der Strom I_{P} im Leiter erzeugt im Ringkern 14 eine magnetische Flussdichte B, deren Gleichstrom- und niederfrequenten Anteile durch den Hall-Sensor 18 erfasst werden. Das Ausgangssignal des Hall-Sensors 18 wird im ersten Verstärker 22 verstärkt und in der zweiten Auswertungsschaltung 38 durch den Tiefpass 40 geleitet. Die zweite Auswertungsschaltung 38 kompensiert außerdem die Übertragungsfunktion G_{Hall} des Hall-Sensors 18. Letztere (einschließlich der Empfindlichkeit und des Offsets des Hall-Sensors 18) wird anhand des Kalibriersignals des Generators 30, das durch die Kalibrierwicklung 28 ein bekanntes Magnetfeld im Ringkern 14 erzeugt, durch die dritte Auswertungsschaltung 42 evaluiert und dient zur selbsttätigen Einstellung von Parametern der zweiten Auswertungsschaltung 38. Die auf den Generator 30 zurückführbaren Signalanteile im Ausgangssignal der zweiten Auswertungsschaltung 38 werden mittels der vierten Auswertungsschaltung 48 entfernt und anschließend (oder vorher) zu den Ausgangssignalen der ersten Auswertungsschaltung 32 addiert, welche die Ausgangssignale der Induktionswicklung 26 zeitlich hochintegriert und durch einen Hochpass 36 leitet. Somit werden die vom Hall-Sensor 18 erfassten niederfrequenten Signalanteile und die von der Induktionswicklung 26 erfassten hochfrequenten Signalanteile kombiniert, um einen flachen und temperaturunabhängigen Frequenzgang des Stromsensors 10 zu erreichen.

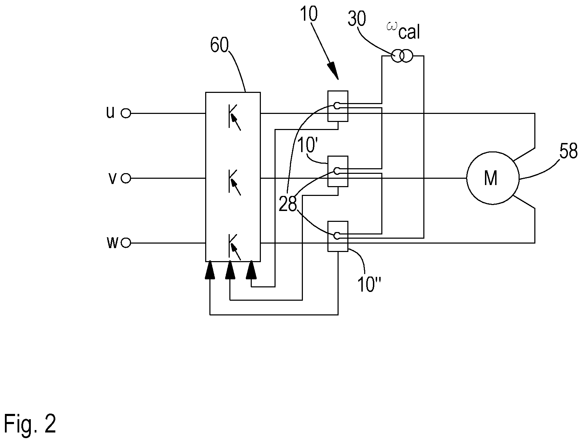

Der erfindungsgemäße Stromsensor 10 lässt sich insbesondere zur Regelung von Antrieben einsetzen. Die Figur 2 zeigt eine Ausführungsform, bei der ein Drehstrommotor 58 von einer Regelung 60 her versorgt wird. In jede Anschlussleitung des Drehstrommotors 58 ist ein Stromsensor 10, 10' oder 10" eingefügt, deren Ausgänge 50 jeweils als Rückkopplungssignale an die Regelung 60 zurückgeführt werden. Die Kalibrierspulen 28 der Stromsensoren 10, 10', 10" sind in Serie geschaltet und werden durch eine einzige Wechselstromquelle 30 beaufschlagt. Da die Änderungsgeschwindigkeit der Summe der Ströme in den Anschlussleitungen des Drehstrommotors 58 klein ist (nach der Kirchhoff'schen Knotenregel sogar gleich null), wird durch diese Ströme in den Kalibrierspulen 28 keine nennenswerte Gegen-EMK induziert, was die Verwendung relativ kleiner Spannungen zur Generierung des Referenzstroms erlaubt und einen relativen einfach Aufbau des Generators 30 ermöglicht.

## Patentansprüche

1. Stromsensor (10) zur Erfassung der Stromstärke (I_{P}) eines einen Leiter (12) durchfließenden Stromes, umfassend:
eine dem Leiter (12) zugeordnete Induktionswicklung (26), welche ein zur zeitlichen Ableitung der Stromstärke (I_{P}) proportionales Induktionssignal bereitstellt,
einen dem Leiter (12) zugeordneten Hall-Sensor (18), der ein zur Stromstärke (I_{P}) proportionales Hall-Signal bereitstellt,
eine dem Hall-Sensor zugeordnete Kalibrierwicklung (28), die durch einen Generator (30) kontinuierlich mit einem sinusförmigen Kalibrierstrom definierter Frequenz (ω_{cal}) beaufschlagbar ist, der ein definiertes Magnetfeld im Hall-Sensor (18) bewirkt,
eine erste Auswertungsschaltung (32), deren Eingang mit dem Induktionssignal beaufschlagbar ist,
eine zweite Auswertungsschaltung (38) mit einem Tiefpass (40), deren Eingang mit dem Hall-Signal beaufschlagbar ist, wobei die Frequenz (ω_{cal}) des Kalibrierstroms (10) unterhalb der Übergangsfrequenz des Tiefpasses (40) der zweiten Auswertungsschaltung (38) liegt,
eine mit dem Ausgang der zweiten Auswertungsschaltung (38) verbundene, dritte Auswertungsschaltung (42), die sich aus einer diskreten Fouriertransformationsschaltung (44) und einem Evaluator (46) zusammensetzt, und die einen dem Kalibrierstrom zuordenbaren Teil des Hall-Signals evaluiert und zur Festlegung eines Parameters der zweiten Auswertungsschaltung (38) verwendet und weiterhin ein Signal hinsichtlich der Amplitude (A) und der Phase (ϕ) der dem Kalibrierstrom definierter Frequenz (ω_{cal}) zuordenbaren Signalanteile der Ausgangsspannung der zweiten Auswertungsschaltung (38) bereitstellt, wobei die Signalanteile von der diskreten Fouriertransformationsschaltung (44) extrahiert werden, und
eine vierte Auswertungsschaltung (48) zur Erzeugung eines die Stromstärke (I_{P}) repräsentierenden Ausgangssignals, das die Summe des Ausgangssignals der ersten Auswertungsschaltung (32) und des Ausgangssignals der zweiten Auswertungsschaltung (38) abzüglich des von der dritten Auswertungsschaltung (42) bereitgestellten, dem Kalibrierstrom zuordenbaren Teils des Ausgangssignals der zweiten Auswertungsschaltung (38) darstellt.

2. Stromsensor (10) nach Anspruch 1, wobei die erste Auswertungsschaltung (32) einen Integrator (34) und einen Hochpass (36) umfasst.

3. Stromsensor (10) nach Anspruch 1 oder 2, wobei der von der dritten Auswertungsschaltung (42) festgelegte Parameter der zweiten Auswertungsschaltung (38) die Übertragungsfunktion (G_{Hall}) des Hall-Sensors (18) und/oder dessen Empfindlichkeit ist.

4. Stromsensor (10) nach einem der Ansprüche 2 oder 3, wobei die Summe der Übertragungsfunktionen (G_{HP}, G_{TP}) des Hochpasses (36) der ersten Auswertungsschaltung (32) und des Tiefpasses (40) der zweiten Auswertungsschaltung (38) 1 beträgt.

5. Stromsensor (10) nach einem der Ansprüche 1 bis 4, wobei die dritte Auswertungsschaltung (42) zur Evaluierung des dem Kalibrierstrom zuordenbaren Teils des Ausgangssignals der zweiten Auswertungsschaltung (38) eine diskrete Fouriertransformation durchführt.

6. Stromsensor (10) nach einem der vorhergehenden Ansprüche, wobei die Induktionswicklung (26) und die Kalibrierwicklung (28) auf einem den Leiter (12) konzentrisch umschließenden Ringkern (14) angeordnet sind, der eine Lücke (16) hat, in welcher der Hall-Sensor (18) angeordnet ist.

7. Regelschaltung (60) zur Kontrolle eines Verbrauchers (58) mit einem Stromsensor (10) nach einem der vorhergehenden Ansprüche.

8. Regelschaltung (60) nach Anspruch 7, wobei der Verbraucher (58) durch drei phasenversetzte Leitungen versorgt wird, denen jeweils ein Stromsensor (10, 10', 10") zugeordnet ist, wobei die Kalibrierwicklungen (28) aller drei Stromsensoren (10, 10', 10") in Serie geschaltet sind.

## Claims

1. Current sensor (10) for detecting the current intensity (Ip) of a current flowing through a conductor (12), comprising:
an induction winding (26) assigned to the conductor (12), said induction winding providing an induction signal proportional to the time derivative of the current intensity (Ip),
a Hall sensor (18) assigned to the conductor (12), said Hall sensor providing a Hall signal proportional to the current intensity (Ip),
a calibration winding (28) assigned to the Hall sensor, a sinusoidal calibration current of defined frequency (ω_{cal}) being able to be applied continuously to said calibration winding by a generator (30), said calibration current bringing about a defined magnetic field in the Hall sensor (18),
a first evaluation circuit (32), to the input of which the induction signal is able to be applied,
a second evaluation circuit (38) having a low-pass filter (40), to the input of which second evaluation circuit the Hall signal is able to be applied, wherein the frequency (ω_{cal}) of the calibration current (10) lies below the transition frequency of the low-pass filter (40) of the second evaluation circuit (38),
a third evaluation circuit (42), which is connected to the output of the second evaluation circuit (38) and which is composed of a discrete Fourier transformation circuit (44) and an evaluator (46) and which evaluates a part of the Hall signal that is assignable to the calibration current and uses said part to define a parameter of the second evaluation circuit (38) and furthermore provides a signal regarding the amplitude (A) and the phase (ϕ) of the signal components of the output voltage of the second evaluation circuit (38) that are assignable to the calibration current of defined frequency (ω_{cal}), wherein the signal components are extracted by the discrete Fourier transformation circuit (44), and
a fourth evaluation circuit (48) for generating an output signal representing the current intensity (Ip), said output signal constituting the sum of the output signal of the first evaluation circuit (32) and the output signal of the second evaluation circuit (38) minus the part of the output signal of the second evaluation circuit (38) that is assignable to the calibration current and is provided by the third evaluation circuit (42).

2. Current sensor (10) according to Claim 1, wherein the first evaluation circuit (32) comprises an integrator (34) and a high-pass filter (36).

3. Current sensor (10) according to Claim 1 or 2, wherein the parameter of the second evaluation circuit (38) that is defined by the third evaluation circuit (42) is the transfer function (G_{Hall}) of the Hall sensor (18) and/or the sensitivity thereof.

4. Current sensor (10) according to either of Claims 2 and 3, wherein the sum of the transfer functions (G_{HP}, G_{TP}) of the high-pass filter (36) of the first evaluation circuit (32) and of the low-pass filter (40) of the second evaluation circuit (38) amounts to 1.

5. Current sensor (10) according to any of Claims 1 to 4, wherein the third evaluation circuit (42) carries out a discrete Fourier transformation for the purpose of evaluating the part of the output signal of the second evaluation circuit (38) that is assignable to the calibration current.

6. Current sensor (10) according to any of the preceding claims, wherein the induction winding (26) and the calibration winding (28) are arranged on a toroidal core (14), concentrically enclosing the conductor (12) and having a gap (16), the Hall sensor (18) being arranged in said gap.

7. Control circuit (60) for controlling a load (58) with a current sensor (10) according to any of the preceding claims.

8. Control circuit (60) according to Claim 7, wherein the load (58) is supplied by three phase-offset lines, a respective current sensor (10, 10', 10") being assigned thereto, wherein the calibration windings (28) of all three current sensors (10, 10', 10") are connected in series.

## Revendications

1. Détecteur de courant (10) pour détecter l'intensité de courant (Iₚ) d'un courant passant dans un conducteur (12), comprenant :
un enroulement d'induction (26) associé au conducteur (12), qui fournit un signal d'induction proportionnel à la dérivée temporelle de l'intensité de courant (Iₚ),
un détecteur Hall (18) associé au conducteur (12), qui fournit un signal Hall proportionnel à l'intensité de courant (Iₚ),
un enroulement d'étalonnage (28) associé au détecteur Hall, auquel un générateur (30) peut appliquer en continu un courant d'étalonnage sinusoïdal de fréquence définie (ω_{cal}) provoquant un champ magnétique défini dans le détecteur Hall (18),
un premier circuit d'évaluation (32) à l'entrée duquel peut être appliqué le signal d'induction,
un deuxième circuit d'évaluation (38) comportant un filtre passe-bas (40) à l'entrée duquel peut être appliqué le signal Hall, dans lequel la fréquence (ω_{cal}) du courant d'étalonnage (10) est inférieure à la fréquence de transition du filtre passe-bas (40) du deuxième circuit d'évaluation (38),
un troisième circuit d'évaluation (42) connecté à la sortie du deuxième circuit d'évaluation (38) et composé d'un circuit de transformation de Fourier discrète (44) et d'un évaluateur (46),
et qui évalue une partie du signal Hall pouvant être associée au courant d'étalonnage et l'utilise pour déterminer un paramètre du deuxième circuit d'évaluation (38) et qui fournit en outre un signal relatif à l'amplitude (A) et à la phase (ϕ) des composantes de signal de la tension de sortie du deuxième circuit d'évaluation (38), qui peuvent être associées au courant d'étalonnage de fréquence définie (ω_{cal}), dans lequel les composantes de signal sont extraites par le circuit de transformation de Fourier discrète (44), et
un quatrième circuit d'évaluation (48) destiné à générer un signal de sortie représentant l'intensité de courant (Iₚ) qui représente la somme du signal de sortie du premier circuit d'évaluation (32) et du signal de sortie du deuxième circuit d'évaluation (38) moins la partie du signal de sortie du deuxième circuit dévaluation (38), qui peut être associée au courant d'étalonnage et qui est fournie par le troisième circuit d'évaluation (42).

2. Détecteur de courant (10) selon la revendication 1, dans lequel le premier circuit d'évaluation (32) comprend un intégrateur (34) et un filtre passe-haut (36).

3. Détecteur de courant (10) selon la revendication 1 ou 2, dans lequel le paramètre du deuxième circuit d'évaluation (38) déterminé par le troisième circuit d'évaluation (42) est la fonction de transfert (G_{Hall}) du détecteur Hall (18) et/ou sa sensibilité.

4. Détecteur de courant (10) selon l'une des revendications 2 ou 3, dans lequel la somme des fonctions de transfert (G_{HP}, G_{TP}) du filtre passe-haut (36) du premier circuit d'évaluation (32) et du filtre passe-bas (40) du deuxième circuit d'évaluation (38) est égale à 1.

5. Détecteur de courant (10) selon l'une des revendications 1 à 4, dans lequel le troisième circuit d'évaluation (42) effectue une transformation de Fourier discrète pour évaluer la partie du signal de sortie du deuxième circuit d'évaluation (38) qui peut être associée au courant d'étalonnage.

6. Détecteur de courant (10) selon l'une des revendications précédentes, dans lequel l'enroulement d'induction (26) et l'enroulement d'étalonnage (28) sont disposés sur un noyau annulaire (14) entourant concentriquement le conducteur (12) et présentant un interstice (16) dans lequel est disposé le détecteur Hall (18) .

7. Circuit de réglage (60) destiné à commander un appareil consommateur (58) au moyen d'un détecteur de courant (10) selon l'une des revendications précédentes.

8. Circuit de réglage (60) selon la revendication 7, dans lequel l'appareil consommateur (58) est alimenté par trois lignes déphasées auxquelles est associé un détecteur de courant (10, 10', 10"), dans lequel les enroulements d'étalonnage (28) de la totalité des trois détecteurs de courant (10, 10', 10") sont connectés en série.
